**Europäisches Patentamt**

**European Patent Office**

**Office européen des brevets**

(19)

(11) Veröffentlichungsnummer: **0 123 997**
**B1**

(12)

# EUROPÄISCHE PATENTSCHRIFT

(45) Veröffentlichungstag der Patentschrift:
**29.06.88**

(21) Anmeldenummer: **84104246.8**

(22) Anmeldetag: **14.04.84**

(51) Int. Cl.⁴: **H 01 P 5/12,** H 03 B 9/14,
H 03 F 3/68

(54) **Anordnung zur synchronisierten Erzeugung oder Verstärkung von Hochfrequenzleistung, insbesondere im Millimeterwellenbereich.**

(30) Priorität: **16.04.83 DE 3313902**

(43) Veröffentlichungstag der Anmeldung:
**07.11.84 Patentblatt 84/45**

(45) Bekanntmachung des Hinweises auf die Patenterteilung:
**29.06.88 Patentblatt 88/26**

(84) Benannte Vertragsstaaten:
**AT BE CH DE FR GB IT LI LU NL**

(56) Entgegenhaltungen:
CH-A-446 540
DE-A-3 114 598
GB-A-963 414
GB-A-970 816
GB-A-1 028 178
US-A-3 928 806
US-A-4 058 780

PROCEEDINGS OF THE IEEE, Band 55, Nr. 2,
Februar 1967, Seiten 243-245, New York; USA; H.
FUKUI et al.: "Time-sequential operation of
multiple pulsed oscillators as a CW microwave
source"
PATENTS ABSTRACTS OF JAPAN, Band 3, Nr. 89,
28. Juli 1979, Seite 58E126; & JP - A - 54 66753
(FUJITSU K.K.) 29.05.1979
PATENTS ABSTRACTS OF JAPAN, Band 4, Nr. 4, 12.
Januar 1980, Seite 13E164; & JP - A - 54 143 044

(73) Patentinhaber: **Licentia Patent- Verwaltungs- GmbH,
Theodor- Stern- Kai 1, D-6000 Frankfurt/Main 70
(DE)**

(72) Erfinder: **Barth, Helmut, Dipl.- Ing., Eichenstrasse
38, D-7904 Erbach (DE)**
Erfinder: **Menzel, Wolfgang, Dr.- Ing., Rehweg 9,
D-7913 Senden (DE)**
Erfinder: **Rembold, Bernhard, Dr,.Ing., Am
Batzenberg 15, D-7910 Neu- Ulm (DE)**
Erfinder: **Solbach, Klaus, Dr.- Ing., Lärchenstrasse
12, D-7913 Senden (DE)**

(74) Vertreter: **Schulze, Harald Rudolf, Dipl.- Ing.,
Licentia Patent- Verwaltungs- GmbH Theodor-
Stern- Kai 1, D-6000 Frankfurt/Main 70 (DE)**

(56) Entgegenhaltungen: (Fortsetzung)
(MITSUBISHI DENKI K.K.) 07.11.1979

## Beschreibung

Anordnung zur synchronisierten Erzeugung oder Verstärkung von Hochfrequenzleistung, insbesondere im Millimeterwellenbereich.

Die Erfindung betrifft eine Anordnung nach dem Oberbegriff des Anspruchs 1, wie sie aus der DE-A-3 114 598 bekannt ist und weiter unten ausführlich erläutert wird.

Die Ausgangsleistung von Halbleiter-Oszillatoren (Gunn- oder Impatt-Oszillatoren) im Millimeterwellenbereich nimmt bekanntlich mit wachsender Frequenz f nach der Gesetzmäßigkeit $I/f...I/f^2$ ab. Um bei höheren Frequenzen (> 30 GHz) für verschiedene Anwendungszwecke ausreichende Ausgangsleistung zu erreichen, werden deshalb Leistungsadditionsschaltungen benutzt, die die Leistung von mehreren Halbleitern kohärent addieren. Solche Schaltungen können entweder als unsynchronisierte oder synchronisierte Oszillatoren oder als lineare Verstärker arbeiten.

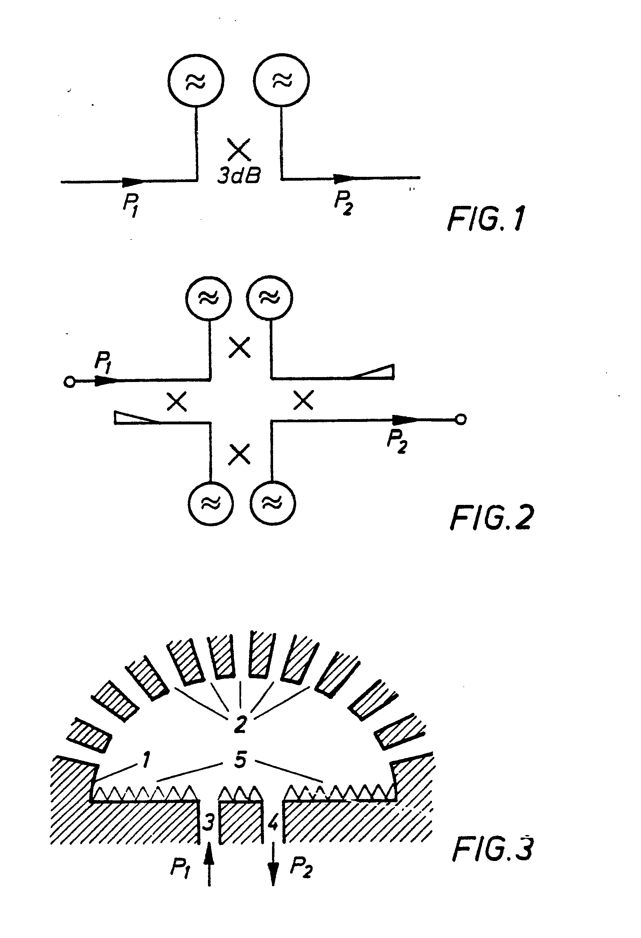

Eine bekannte Anordnung als Beispiel für einen synchronisierten Oszillator zeigt FIG. 1.

Die Eingangsleistung $P_1$ synchronisiert über einen 3 dB-Richtkoppler zwei Oszillatoren. Das reflektierte und verstärkte Signal addiert sich am Ausgang zur Ausgangsleistung $P_1$.

Aufbauend auf diesem Prinzip lassen sich umfangreiche Leistungsadditionswerke realisieren. Beispiele hierfür werden im Nizushina S.e.a.: A corporate structure for combining power from 3 oscillators. IEEE-MTT-S Int. Microw. Sympos. Digest Washington, 1980, pp. 168-170 gezeigt. Eine bekannte Erweiterung unter Benutzung von vier 3 dB-Kopplern zeigt FIG. 2. Die Realisierung dieser Anordnung erfordert wegen der Koppler einen hohen feinmechanischen Aufwand. Die unvermeidlichen Kopplerverluste reduzieren die Ausgangsleistung.

Eine weitere bekannte Leistungsadditionsschaltung ist in Kurokawa, K.; Magalhaes. F.M.: An X-band 10-Watt multiple-Impatt-Oscillator. Proc. IEEE, 59, 1971, p. 102 beschrieben. Dabei sind mehrere Dioden an einen gemeinsamen Resonator gekoppelt. Jede Diode sitzt bei der dort beschriebenen Ausführung an einem Ende eines Koaxialleiters, welcher an eine Innenwand eines Wellenleiterresonators angekoppelt ist, während das andere Ende der Koaxialleitungen jeweils mit einem getaperten Absorber abgeschlossen ist.

Wegen der mit größer werdender Frequenz nicht beliebig reduzierbaren Dioden- und Chokeabmessungen läßt sich dieses Prinzip nur schwer bei hohen Frequenzen (z. B. 90 GHz) realisieren.

Beide bekannte Leistungsadditionsschaltungen haben den Nachteil, daß in der Praxis nicht mehr als acht bis zwölf Dioden parallel geschaltet werden können. Das bedeutet eine maximale Ausgangsleistung von etwa der 10-fachen Diodeneinzelleistung.

Eine Anordnung, mit der die Leistung von noch mehr Dioden kombiniert werden kann, ist in der DE-A-3 114 598 beschrieben (FIG. 3). Diese Anordnung besteht aus zwei Metallplatten, die im Abstand von ca. λ/2 angeordnet sind. Entlang einer elliptischen Kontur 1 sind Oszillatoren 2 oder Verstärker angeordnet. In einem Brennpunkt 3 der Ellipse wird ein Synchronisationssignal $P_1$ eingespeist. Ist der "Ziehwinkel" (Phase) zwischen Synchronisationssignal und Oszillatorsignal für alle Oszillatoren gleich, so wird praktisch die gesamte Oszillatorleistung im zweiten Brennpunkt 4 der Ellipse ausgekoppelt. Die Wände der Anordnung sind teilweise mit Absorbermaterial 5 ausgekleidet.

Diese Anordnung weist aber noch folgende Nachteile auf:
- Die eingesetzten Dioden streuen. Damit muß jeder Oszillator individuell abgestimmt werden, wodurch der "Ziehwinkel" von Oszillator zu Oszillator variiert. Wird aber auf maximale Leistung am Ausgang der Anordnung abgestimmt, ist die maximale Leistung der Einzeloszillatoren nicht erreichbar, und die Synchronisationsbandbreite nimmt ab.
- Die Oszillatoren sind nicht voneinander entkoppelt. Änderungen an einem Oszillator beeinflussen auch die anderen, im wesentlichen über die Anpassung der Einzeloszillatoren an den Feldraum der Kombinationsanordnung. Dies ist jedoch besonders für Impattdioden sehr kritisch und kann im schlimmsten Fall zur Zerstörung der Diode führen.

Aus Proceedings of the IEEE, Band 55, Nr. 2, Februar 1967, Seiten 243-245, ist eine Anordnung zur Kombination der Signale mehrerer gepulster Mikrowellenoszillatoren zu einem kohärenten CW-Signal bekannt. Die Oszillatoren werden sequentiell betrieben und von einem CW-Oszillator synchronisiert. Die Aufteilung der Synchronisierleistung und die Kombination der Ausgangsleistungen sind voneinander getrennt und entkoppelt. Die gepulsten Oszillatoren sowie die Aufteilungs- und Kombinationseinrichtungen sind an Viertor-Zirkulatoren angeschlossen. Zur Phaseneinstellung der Oszillatoren liegen jeweils Phasenschieber in den Oszillatorzweigen. Diese bewirken eine unerwünschte Dämpfung der Ausgangsleistung. Über den Aufbau der Aufteilungseinrichtung für die Synchronisierleistung ist nichts ausgesagt. Die Kombination der Ausgangsleistungen soll mit synchron zum jeweiligen Oszillator geschalteten Diodenschaltern erfolgen. Diese bewirken eine zusätzliche unerwünschte Dämpfung im Ausgangssignal und sind aufwendig im Aufbau.

Aufgabe der Erfindung ist es daher, eine Anordnung der eingangs genannten Art zu schaffen, welche die aufgezählten Nachteile des Standes der Technik nicht aufweist. Im einzelnen soll die erfindungsgemäße Anordnung folgende Bedingungen erfüllen:
- Die einzelnen Oszillatoren sind voneinander entkoppelt.
- Dämpfungsverluste sind so gering wie möglich zu halten.

- Die Oszillatoren sind einzeln und unabhängig von anderen Parametern auf maximale Leistung und auf Sollfrequenz abstimmbar.
- Die Einkoppelphase ist für jeden Oszillator getrennt und unabhängig einstellbar.
- Die Anordnung soll kompakt sein.

Die Erfindung ist im Patentanspruch 1 gekennzeichnet. Die weiteren Ansprüche beinhalten vorteilhafte Ausführungen der Erfindung.

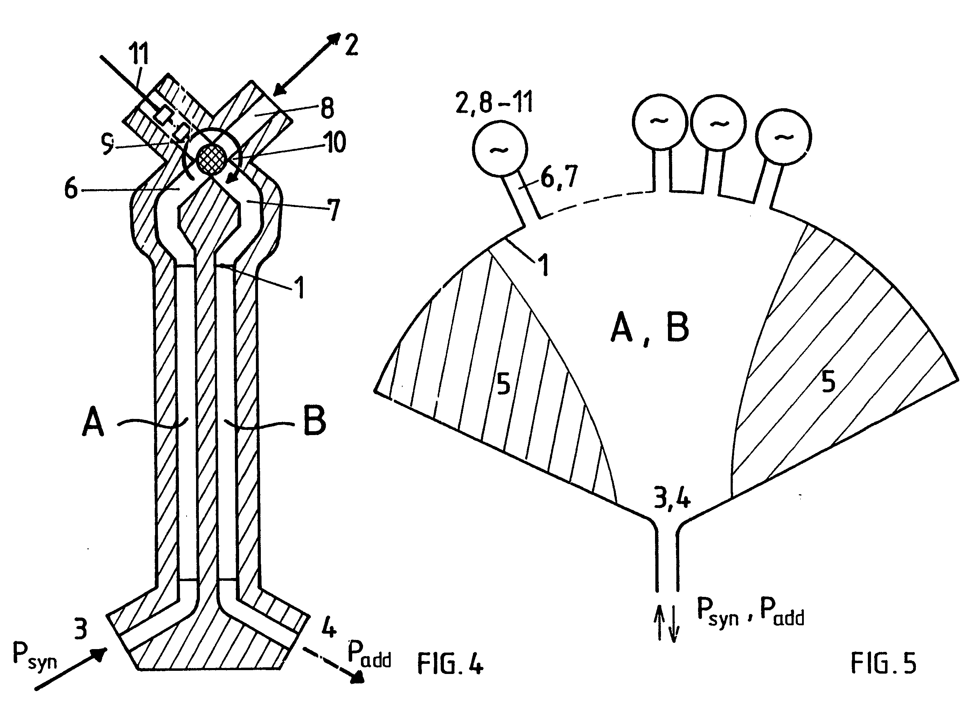

Die Erfindung wird im folgenden anhand der FIG. 4 und 5 näher erläutert. Die Erfindung geht aus von einer Anordnung gemäß FIG. 3 mit quasioptischer Aufteilung der Synchronisationsleistung bzw. Kombination der Ausgangsleistungen der Einzeloszillatoren.

FIG. 4 zeigt einen Schnitt durch die erfindungsgemäße Anordnung. Der Feldraum A zur Verteilung der Synchronisationsleistung $P_{syn}$ ist von dem zur Leistungsaddition B getrennt und besteht jeweils aus einem Kreiszylindersegment, wie in FIG. 5 dargestellt. Beide Feldräume sind in zwei Ebenen übereinander angeordnet. Entkopplung, Synchronisation und Phaseneinstellung erfolgen jeweils über einen Viertorzirkulator 10, der z. B. als E-Ebenen-Zirkulator ausgebildet und vor jedem Einzeloszillator 2 angeordnet ist. Leistungsaddition und Leistungsteilung erfolgen in diesem Fall in der H-Ebene. Völlig analog können H- und E-Ebene auch vertauscht werden. Das Synchronisationssignal $P_{syn}$ wird im Feldraum A aufgeteilt und jeweils in das erste Tor 6 des Zirkulators 10 eingespeist. Von dort gelangt es zum zweiten Tor 9, von wo es mit einer durch die Stellung eines Kurzschlußschiebers 11 vorgebbaren Phasenverschiebung auf den Einzeloszillator 2 am dritten Tor 8 gelangt. Die synchronisierte Leistung des Oszillators gelangt über das vierte Tor 7 zum Feldraum B, wo die Anteile der Einzeloszillatoren bei richtiger Phaseneinstellung addiert und am Ausgang 4 ausgekoppelt werden. Durch den Zirkulator 10 werden jeweils die Feldräume A, B, der Phasenschieber 11 und der Einzeloszillator 2 voneinander entkoppelt, so daß die oben genannten Bedingungen erfüllt sind. Die Viertorzirkulatoren 10 können auch aus zwei Dreitorzirkulatoren aufgebaut sein.

Bei optimaler Einstellung des Einzeloszillators läßt sich dessen Phase individuell und unabhängig von anderen Parametern so einstellen, daß am Ausgang 4 maximale Gesamtleistung erreicht wird. Die etwas erhöhte Dämpfung durch den Phasenschieber 11 ist in den Synchronisationszweig gelegt, wo sie weniger störend wirkt. Für die Oszillatoren 2 bleibt lediglich die Dämpfung zwischen zwei benachbarten Toren 8, 9 des Zirkulators 10 übrig, die aber im allgemeinen weniger als 0,5 dB beträgt. Dieser Nachteil, sowie der erhöhte Aufwand durch die Zirkulatoren 10 werden aber bei weitem durch die bereits genannten Vorteile kompensiert. Dazu kommt noch eine erhebliche Aufwandsersparnis beim Optimieren und Abstimmen der Oszillatoren.

**Patentansprüche**

1. Anordnung zur synchronisierten Erzeugung oder Verstärkung von Hochfrequenzleistung, insbesondere im mm-Wellen-Bereich, mit einer quasioptisch aufgebauten Leistungsteileranordnung (A) für ein Synchronisationssignal ($P_{syn}$), welches einer Anzahl Oszillatoren zugeführt ist und einer quasioptisch aufgebauten Leistungsadditionsanordnung (B) zur Kombination der synchronisierten Ausgangsleistungen ($P_{add}$) der Oszillatoren, wobei die Leistungsteiler- (A) und die Leistungsadditionsanordnung (B) als Kreissegmente (1) aufgebaut sind, die senkrecht zur Kreisebene durch Metallplatten im Abstand von $\leq \lambda/2$ begrenzt sind und der Eingang (3) bzw. der Ausgang (4) der Anordnung sich im Mittelpunkt des Kreises befinden, während die Oszillatoren (2) über Hohlleiteröffnungen (6, 7) in der Kreiskontur (1) angekoppelt sind, dadurch gekennzeichnet, daß die Leistungsteileranordnung (A) und die Leistungsadditionsanordnung (B) voneinander getrennt in zwei Ebenen übereinander angeordnet sind und deren jeweilig übereinander angeordneten Hohlleiteröffnungen jeweils an ein erstes (6) und ein viertes Tor (7) einer Anzahl von Viertorzirkulatoren (10) angeschlossen sind, daß an einem dritten Tor (8) der jeweiligen Viertorzirkulatoren (10) jeweils ein Oszillator (2) angeschlossen ist, daß an einem zweiten Tor (9) der jeweiligen Viertorzirkulatoren (10), welches sich im Synchronisationssignalweg befindet, jeweils ein Kurzschlußschieber (11) zur Phaseneinstellung des Oszillatorsignals angeschlossen ist, und daß die Zirkulationsrichtung vom ersten über das zweite, über das dritte und schließlich zum vierten Tor gegeben ist. (FIG. 4 und 5.)

2. Anordnung nach Anspruch 1, dadurch gekennzeichnet, daß die Leistungsteilung und die Leistungsaddition in der H-Ebene stattfinden.

3. Anordnung nach Anspruch 2, dadurch gekennzeichnet, daß der Viertorzirkulator (10) als E-Ebenen-Zirkulator ausgeführt ist.

4. Anordnung nach Anspruch 1, dadurch gekennzeichnet, daß die Leistungsteilung und Leistungsaddition in der E-Ebene stattfinden.

5. Anordnung nach Anspruch 4, dadurch gekennzeichnet, daß der Viertorzirkulator (10) als H-Ebenen-Zirkulator ausgeführt ist.

6. Anordnung nach einem der vorhergehenden Ansprüche, dadurch gekennzeichnet, daß der Viertorzirkulator (10) aus zwei Dreitorzirkulatoren zusammengesetzt ist.

**Claims**

1. Arrangement for the synchronised generation or amplification of high frequency power, in particular in the millimetre wave range, with a quasi-optically constructed power divider arrangement (A) for a synchronising signal ($P_{syn}$), which is fed to a number of oscillators, and a quasi-optically constructed power addition arrangement (B) for the combination of the synchronised output powers ($P_{add}$) of the oscillators, wherein the power divider arrangement (A) and the power addition arrangement (B) are built up as circular segments (1), which are bounded perpendicularly to the circular plane by metal plates at spacings which are at most equal to $\lambda/2$, and the input (3) and the output (4) of the arrangement are respectively disposed in the centre of the circle, while the oscillators (2) are coupled in by way of waveguide openings (6, 7) in the circular outline (1), characterised thereby, that the power divider arrangement (A) and power addition arrangement (B) are arranged separately each from the other in two planes one above the other and their respective waveguide openings, arranged one above the other, are each connected to a respective first port (6) and a respective fourth port (7) of a number of four-port circulators (10), a respective oscillator (2) is connected to a third port (8) of the respective four-port circulators (10), that a respective short-circuit slide (11) for the phase adjustment of the oscillator signal is connected to a second port (9) of the respective four-port circulators (10), which is disposed in the synchronising signal path, and that the direction of circulation is given from the first port by way of the second port, by way of the third port and finally to the fourth port (Figs. 4 and 5).

2. Arrangement according to claim 1, characterised thereby, that the power division and the power addition take place in the H-plane.

3. Arrangement according to claim 2, charactarised thereby, that the four-port circulator (10) is constructed as E-plane circulator.

4. Arrangement according to claim 1, characterised thereby, that the power division and the power addition take place in the E-plane.

5. Arrangement according to claim 4, characterised thereby, that the four-port circulator (10) is constructed as H-plane circulator.

6. Arrangement according to one of the preceding claims, characterised thereby, that the four-port circulator (10) is composed of two three-port circulators.

**Revendications**

1. Dispositif de génération ou d'amplification synchrone de puissance haute fréquence, en particulier dans la bande des ondes millimétriques, avec un diviseur de puissance quasioptique (A) pour un signal de synchronisation ($P_{syn}$), qui est appliqué à plusieurs oscillateurs, et un dispositif quasioptique d'addition de puissance (B) pour la combinaison des puissances de sortie synchronisées ($P_{add}$) des oscillateurs, le dispositif diviseur (A) et le dispositif additionneur (B) de puissance étant constitués par des segments de cercle (1), qui sont limités perpendiculairement au plan du cercle par des plaques métalliques présentant un écartement $\leqslant/2$ et l'entrée (3) ou la sortie (4) du dispositif se trouvant au centre du cercle, tandis que les oscillateurs (2) sont accouplés par des orifices de guide d'ondes (6, 7) sur le contour du cercle (1), ledit dispositif étant caractérisé en ce que le dispositif diviseur de puissance (A) et le dispositif additionneur de puissance (B) sont séparés et superposés dans deux plans, et leurs orifices de guide d'ondes superposés sont reliés chacun à une première (6) et à une quatrième (7) voie de plusieurs circulateurs à quatre voies (10); un circulateur (2) est relié à une troisième voie (8) de chaque circulateur à quatre voies (10); un piston à piège (11) est relié à une deuxième voie (9) de chaque circulateur à quatre voies (10) située dans le circuit du signal de synchronisation, pour le réglage de la phase du signal d'oscillateur; et la circulation s'effectue de la première à la deuxième, puis à la troisième et enfin à la quatrième voie (figures 4 et 5).

2. Dispositif selon revendication 1, caractérisé en ce que la division de puissance et l'addition de puissance s'effectuent dans le plan H.

3. Dispositif selon revendication 2, caractérisé en ce que le circulateur à quatre voies (10) est réalisé en circulateur dans le plan E.

4. Dispositif selon revendication 1, caractérisé en ce que la division de puissance et l'addition de puissance s'effectuent dans le plan E.

5. Dispositif selon revendication 4, caractérisé en ce que le circulateur à quatre voies (10) est réalisé en circulateur dans le plan H.

6. Dispositif selon une quelconque des revendications 1 à 5, caractérisé en ce que le circulateur à quatre voies (10) est constitué par deux circulateurs à troies voies.

FIG.1

FIG.2

FIG.3

FIG. 4

FIG. 5

0 123 997